# EUROPEAN PATENT APPLICATION

(11) **EP 4 572 069 A1**
(43) Date of publication of application: **18.06.2025**
(21) Application number: 23851281.8
(22) Date of filing: 08.05.2023
(51) Int. Cl.: H02J 3/38

(54) **COMBINER DEVICE, PHOTOVOLTAIC SYSTEM AND FAULT DETECTION METHOD**

(30) Priority: 09.08.2022 CN 202210951810
(71) Applicant: Sungrow Power Supply Co., Ltd., Hefei, Anhui 230088 (CN)
(72) Inventor: WANG, Changyou, Hefei, Anhui 230088 (CN); YAN, Shichao, Hefei, Anhui 230088 (CN)
(74) Representative: Zacco Norway AS
(86) International application number: PCT/CN2023/092680
(87) International publication number: WO 2024/032051

(57) **Abstract**

The present application discloses a combiner device, a photovoltaic system and a fault detection method. The combiner device comprises at least two photovoltaic strings connected in parallel; and further comprises a current measurement circuit, a voltage measurement circuit, an insulation resistance measurement circuit and a controller. The current measurement circuit is used for measuring the current of each photovoltaic string; the voltage measurement circuit is used for measuring the voltage of the photovoltaic strings connected in parallel; the insulation resistance measurement circuit is used for measuring the insulation resistance of the photovoltaic strings connected in parallel; and the controller determines, according to the current, the voltage and the insulation resistance, whether the photovoltaic strings have a reverse connection fault. When performing determination on the photovoltaic strings, three parameters, i.e., the current, the voltage and the insulation resistance, are comprehensively determined, so that whether the photovoltaic strings really have the reverse connection fault can be accurately determined, and the impact on power generation capacity caused by erroneous determination is reduced. Whether the reverse connection fault occurs cannot be accurately determined only by means of the current, and other faults may also cause current reverse.

## Description

The present application claims priority to Chinese Patent Application No. 202210951810.X, titled "COMBINER DEVICE, PHOTOVOLTAIC SYSTEM AND FAULT DETECTION METHOD", filed on August 09, 2022 with the China National Intellectual Property Administration, which is incorporated herein by reference in its entirety.

### FIELD

The present disclosure relates to the technical field of photovoltaic power generation, and in particular to a combiner device, a photovoltaic system and a fault detection method.

### BACKGROUND

With the continuous development of new energy, the photovoltaic power generation is widely used. Generally, the photovoltaic system includes a combiner box. Using the combiner box, multiple photovoltaic strings are connected in parallel to combine currents, and then the combined currents are inputted to a DCAC circuit. Each of the photovoltaic strings includes multiple photovoltaic modules connected in series, and each of the photovoltaic modules includes multiple solar cells connected in series. Multiple diodes are reversely connected in parallel between a positive output terminal and a negative output terminal of a photovoltaic module and connection points of the corresponding solar cells. For example, three diodes may be reversely connected in parallel. The diodes are reversely connected in parallel for providing a bypass circuit in case of abnormal solar cells, avoiding damage to the solar cells.

However, in practical applications, wiring errors are inevitable in constructions. For example, a photovoltaic string may be reversely connected, and then the currents of other photovoltaic strings connected in parallel flow to the reversely connected photovoltaic string, resulting in the photovoltaic string reversely connected to be damaged by overcurrent. To avoid the damage to the photovoltaic module reversely connected, two photovoltaic strings are often connected in parallel to combine currents. Each of the photovoltaic strings is provided with a current detection device, which determines whether the photovoltaic string is reversely connected by detecting whether the current is reversed.

However, misjudgment often occurs in the practical applications of the conventional technology. For example, in a case that open-circuit voltages of the photovoltaic strings are different, a reverse current may occur when photovoltaic modules are connected in parallel to combine currents. In addition, when cables of the photovoltaic strings are damaged and short circuited to ground, a reverse current may occur. Therefore, it cannot be accurately determine whether a reversed connection fault occurs by detecting the current of the photovoltaic strings.

### SUMMARY

In view of this, a combiner device, a photovoltaic system and a fault detection method are provided according to the present disclosure, to accurately determine whether a reverse connection fault occurs in photovoltaic strings.

In order to solve the above technical problems, the following technical solutions are provided according to the present disclosure.

A combiner device is provided according to the present disclosure. The combiner device includes at least two photovoltaic strings connected in parallel. The combiner device further includes a current detection circuit, a voltage detection circuit, an insulation impedance detection circuit, and a controller. The current detection circuit is configured to detect a current of each of the photovoltaic strings. The voltage detection circuit is configured to detect a voltage of the photovoltaic strings connected in parallel. The insulation impedance detection circuit is configured to detect an insulation impedance of the photovoltaic strings connected in parallel. The controller is configured to determine whether a reverse connection fault occurs in the photovoltaic strings based on the current, the voltage, and the insulation impedance.

Preferably, the controller is configured to determine that a reverse connection fault occurs in a first photovoltaic string in a case that an absolute value of the voltage is less than a preset voltage, the insulation impedance is greater than a preset impedance value and a current of the first photovoltaic string is less than zero. The first photovoltaic string is any one of the at least two photovoltaic strings connected in parallel.

Preferably, the controller is further configured to determine that a voltage mismatch fault occurs in a first photovoltaic string in a case that the voltage is greater than the preset voltage and the current of the first photovoltaic string is less than zero. The first photovoltaic string is any one of the at least two photovoltaic strings connected in parallel.

Preferably, the controller is further configured to determine that a short-circuit fault occurs in a first photovoltaic string in a case that the insulation impedance is less than the preset impedance value and the current of the first photovoltaic string is less than zero. The first photovoltaic string is any one of the at least two photovoltaic strings connected in parallel.

Preferably, each of photovoltaic modules in the photovoltaic strings includes a diode reversely connected in parallel, and the preset voltage is greater than a sum of conduction voltage drops of diodes reversely connected in parallel in the photovoltaic strings and less than open-circuit voltages of all the photovoltaic strings.

A photovoltaic system is further provided according to the present disclosure. The photovoltaic system includes a DCAC circuit, and at least one combiner device described above. An output terminal of the combiner device is connected to an input terminal of the DCAC circuit.

A fault detection method is further provided according to the present disclosure. The fault detection method is applied to a photovoltaic system. The photovoltaic system includes a DCAC circuit and at least two photovoltaic strings connected in parallel. The method includes: obtaining a current of each of the photovoltaic strings; obtaining a voltage of the photovoltaic strings connected in parallel; obtaining an insulation impedance of the photovoltaic strings connected in parallel; and determining whether a reverse connection fault occurs in the photovoltaic strings based on the current, the voltage, and the insulation impedance.

Preferably, the determining whether a reverse connection fault occurs in the photovoltaic strings based on the current, the voltage, and the insulation impedance includes: determining that a reverse connection fault occurs in a first photovoltaic string in a case that an absolute value of the voltage is less than a preset voltage, the insulation impedance is greater than a preset impedance value and a current of the first photovoltaic string is less than zero. The first photovoltaic string is any one of the at least two photovoltaic strings connected in parallel.

Preferably, the fault detection method further includes: determining that a voltage mismatch fault occurs in a first photovoltaic string in a case that the voltage is greater than the preset voltage and the current of the first photovoltaic string is less than zero. The first photovoltaic string is any one of the at least two photovoltaic strings connected in parallel.

Preferably, the fault detection method further includes: determining that a short-circuit fault occurs in a first photovoltaic string in a case that the insulation impedance is less than the preset impedance value and the current of the first photovoltaic string is less than zero. The first photovoltaic string is any one of the at least two photovoltaic strings connected in parallel.

Preferably, each of photovoltaic modules in the photovoltaic strings includes a diode reversely connected in parallel, and the preset voltage is greater than a sum of conduction voltage drops of diodes reversely connected in parallel in the photovoltaic strings and less than open-circuit voltages of all the photovoltaic strings.

It can be seen that the present disclosure has the following beneficial effects.

With the combiner device according to the present disclosure, it can be accurately determined, based on the three parameters of current, voltage, and insulation impedance, whether a reverse connection fault occurs in photovoltaic strings, reducing the impact of misjudgment on power generation. It cannot be accurately determined whether a reverse connection fault occurs only based on a current due to that other faults may also cause a reverse current. For example, when a current of a photovoltaic string is reversed and an insulation impedance is less than a preset impedance value, it indicates that a short-circuit fault occurs, rather than a reverse connection fault. When a voltage is greater than a preset voltage and a current is reversed, it indicates a voltage mismatch fault occurs. Only when an absolute value of a voltage is less than a preset voltage, an insulation impedance is greater than a preset impedance value and a current is reversed, it is determined that a reverse connection fault occurs. The maintenance personnel dismantle a reversely connected photovoltaic string and then reconnect the photovoltaic string only in case of a reverse connection fault occurs, and other corresponding operations are performed for other faults.

### BRIEF DESCRIPTION OF THE DRAWINGS

FIG. 1 is a schematic diagram of m photovoltaic strings connected in parallel according to an embodiment of the present disclosure;
FIG. 2 is a schematic diagram of photovoltaic modules connected with diodes in parallel reversely according to the present disclosure;
FIG. 3 is a schematic diagram of two photovoltaic strings connected in parallel;
FIG. 4 is a schematic diagram showing two photovoltaic strings connected in parallel and one of the photovoltaic strings being reversely connected;
FIG. 5 is a schematic diagram showing a voltage mismatch occurring in photovoltaic strings connected in parallel;
FIG. 6 is a schematic diagram showing a positive cable and a negative cable of a photovoltaic string being short circuited to ground;
FIG. 7 is a schematic diagram showing a positive cable of PV2 and a negative cable of PV1 being short circuited to ground;
FIG. 8 is a schematic diagram of a combiner device according to an embodiment of the present disclosure;
FIG. 9 is a schematic diagram of photovoltaic strings connected in parallel according to another embodiment of the present disclosure;
FIG. 10 is a schematic diagram showing a voltage mismatch principle according to an embodiment of the present disclosure;
FIG. 11 is a schematic diagram showing IV curves of photovoltaic strings connected in parallel according to an embodiment of the present disclosure;
FIG. 12 is a schematic diagram of a photovoltaic system according to an embodiment of the present disclosure; and
FIG. 13 is a flowchart of a fault detection method according to an embodiment of the present disclosure.

### DETAILED DESCRIPTION OF EMBODIMENTS

Hereinafter, the technical solutions according to the embodiments of the present disclosure are to be described in conjunction with the drawings in the embodiments of the present disclosure.

The terms "first", "second", and the like in the following description are used only for description, and should not be interpreted as indicating or implying relative importance or implying the number of the indicated technical features. Therefore, the features defined by "first" and "second" may explicitly or implicitly include one or more of the features. In the present disclosure, the term "multiple" indicates two or more unless otherwise specified.

In the description of the present disclosure, it should be noted that, unless otherwise explicitly specified and defined, the term "connection" should be understood in a broad sense, for example, the term "connection" may imply a fixed connection, a detachable connection, or an integral connection, or the term "connection" may imply a direct connection or an indirect connection through intermediary. In addition, the term "coupling" may be a way of an electrical connection for signal transmission. The term "coupling" may imply a direct electrical connection or an indirect electrical connection through an intermediate medium.

In order to make the above objectives, features and advantages of the present disclosure more obvious and easier to be understood, the embodiments of the present disclosure are described in detail below in conjunction with the drawings and the embodiments.

The combiner device according to the embodiments of the present disclosure is applied to a photovoltaic system, that is, is applied in the field of photovoltaic power generation. The combiner device may be arranged separately or be integrated in an inverter, which is not limited in the embodiments of the present disclosure. In addition, the number of photovoltaic strings included in the combiner device is not limited in the embodiments of the present disclosure. The combiner device may include at least two photovoltaic strings connected in parallel.

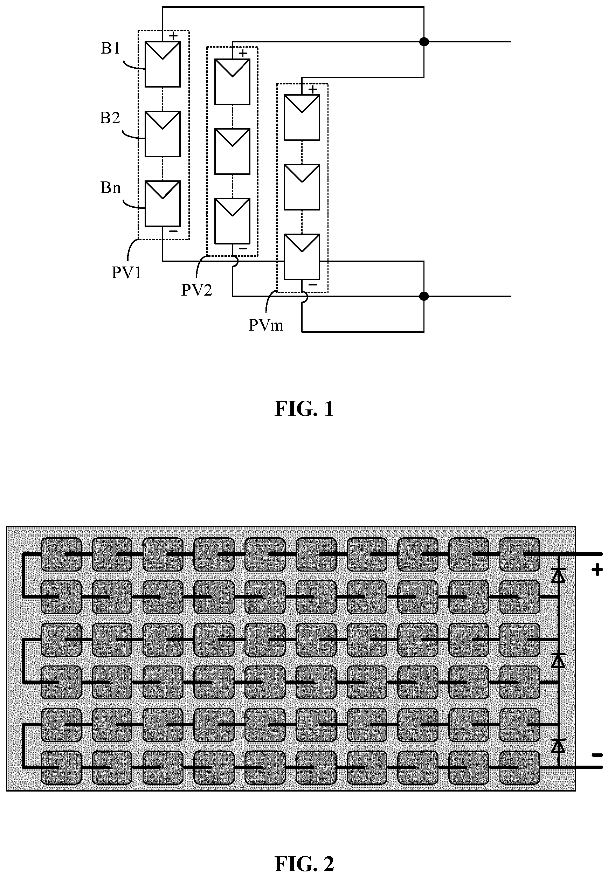

Reference is made to FIG. 1, which is a schematic diagram of m photovoltaic strings connected in parallel according to an embodiment of the present disclosure.

In FIG. 1, m photovoltaic strings are taken as an example for description, including a first photovoltaic string PV1 to an m-th photovoltaic string PVm. The photovoltaic strings PV1 to PVm are connected in parallel, where m is an integer greater than or equal to 2.

Each of the photovoltaic strings includes n photovoltaic modules, that is, a first photovoltaic module B1 to an n-th photovoltaic module Bn. The photovoltaic modules B1, B2, ..., and Bn are connected in series, where n is an integer greater than or equal to 2.

Due to that currents of multiple photovoltaic strings are combined and then are inputted to a DCAC circuit, the device is referred to as a convergence device.

In addition, multiple diodes are reversely connected in parallel between a positive output terminal and a negative output terminal of a photovoltaic module and connection points of the corresponding solar cells to provide a bypass circuit in case of abnormal solar cells, avoiding damage to the solar cells. As shown in FIG. 2, which is a schematic diagram of photovoltaic modules connected with diodes in parallel reversely according to the present disclosure.

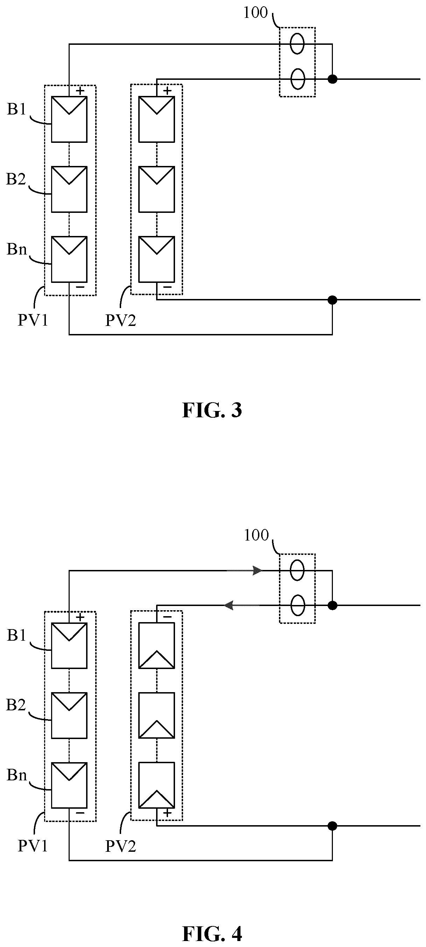

To avoid the damage to photovoltaic modules caused by the reverse connection of photovoltaic strings, a two-in-one solution is adopted according to the conventional technology, that is, two photovoltaic strings are connected in parallel. Referring to FIG. 3, FIG. 3 is a schematic diagram of two photovoltaic strings connected in parallel.

Two photovoltaic strings PV1 and PV2 are connected in parallel, and each of the two photovoltaic strings includes B1, B2, ..., and Bn connected in series. Each of the photovoltaic strings is provided with a current detection device a current detection device 100 (such as, a current sensor or a shunt resistor) for detecting whether a reverse current occurs in a branch of the photovoltaic strings.

Below, a current detection process in a case that a photovoltaic string is reversely connected is described with reference to FIG. 4.

Referring to FIG. 4, FIG. 4 is a schematic diagram showing two photovoltaic strings connected in parallel and one of the photovoltaic strings being reversely connected.

Comparing FIG. 3 and FIG. 4, it can be seen that in FIG. 4, PV1 is connected normally and the positive terminal and the negative terminal of PV2 are reversely connected, thus the current between PV1 and PV2 forms a loop, that is, the current of PV2 is reversed.

In a situation in which a voltage mismatch occurs between photovoltaic strings, the current of PV2 may also be reversed. For the voltage mismatch, it means some of the photovoltaic strings connected in parallel have high voltages and some of the photovoltaic strings connected in parallel have low voltages.

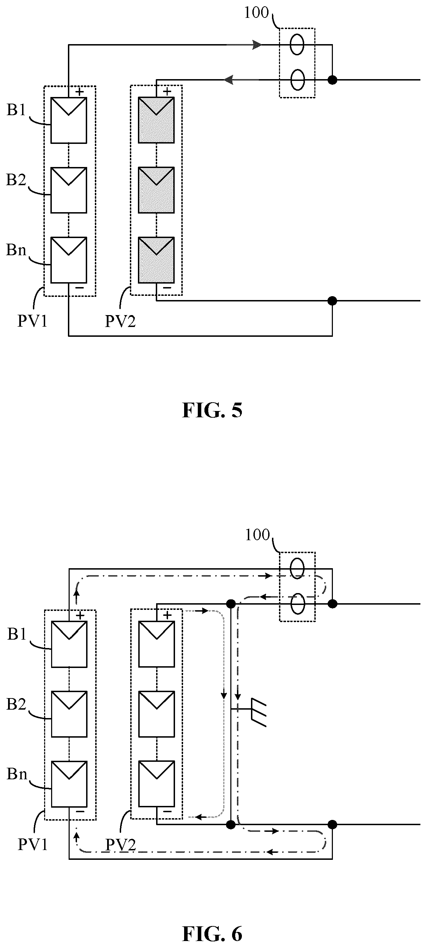

Referring to FIG. 5, FIG. 5 is a schematic diagram showing a voltage mismatch occurring in photovoltaic strings connected in parallel.

It can be seen from FIG. 5 that PV1 and PV2 are both connected normally and there is no reverse connection. However, the current of PV2 is reversed, indicating that the voltage of PV1 is higher than the voltage of PV2.

Further, there is another situation in which a current of a photovoltaic string is reversed. For example, when cables of a photovoltaic string are worn or have insulation failure during installation, the cables of the photovoltaic string may be short circuited to ground. Then, the current detection device may detect a reverse current, and reports a reverse connection fault in the photovoltaic string while the photovoltaic string is not reversely connected.

Referring to FIG. 6, FIG. 6 is a schematic diagram showing a positive cable and a negative cable of a photovoltaic string being short circuited to ground.

A positive cable and a negative cable of a photovoltaic string PV2 are short circuited to ground, and then the current detection device 100 may also detect a reverse current in the photovoltaic string PV2.

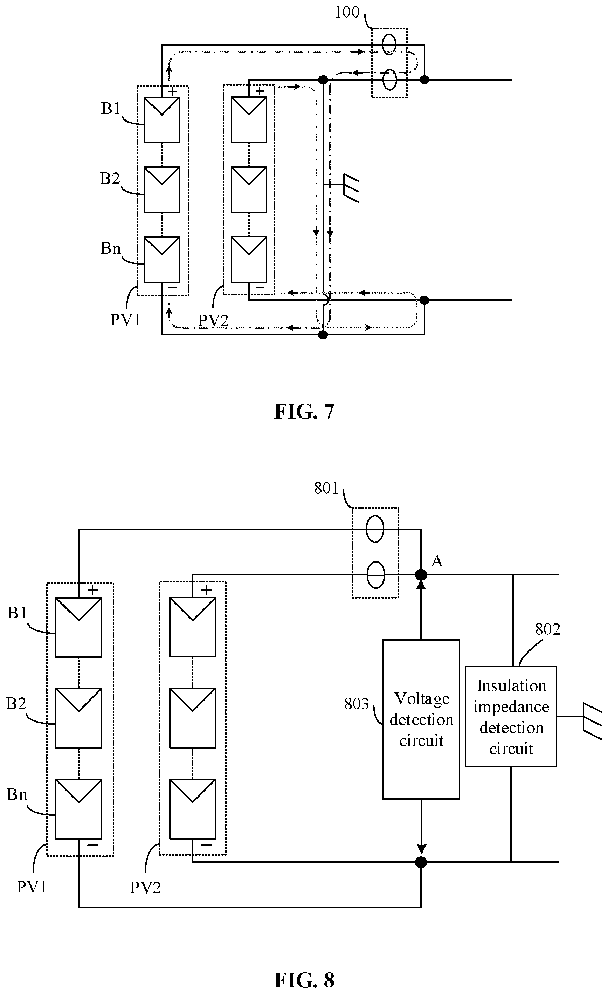

Referring to FIG. 7, FIG. 7 is a schematic diagram showing a positive cable of PV2 and a negative cable of PV1 being short circuited to ground.

Then, the current detection device 100 may also detect a reverse current in the photovoltaic string PV2.

In summary, when a photovoltaic string is reversely connected, a voltage mismatch occurs, or cables a photovoltaic string is short circuited to ground, a reverse current may occur. Thus, it cannot be accurately determine whether a photovoltaic string is reversely connected only by detecting a current. A combiner device according to the embodiments of the present disclosure is described below. With the combiner device, it can be accurately detected whether a photovoltaic string is reversely connected.

Referring to FIG. 8, FIG. 8 is a schematic diagram of a combiner device according to an embodiment of the present disclosure.

The combiner device according to the embodiment of the present disclosure includes at least two photovoltaic strings connected in parallel, and further includes: a current detection circuit 801, a voltage detection circuit 803, an insulation impedance detection circuit 802, and a controller (not shown in FIG. 8).

The current detection circuit 801 is configured to detect a current of each of the photovoltaic strings.

In FIG. 8, two photovoltaic strings connected in parallel are taken as an example for description, that is, a first photovoltaic string PV1 to a second photovoltaic string PV2. More photovoltaic strings connected in parallel may be included. The current detection circuit 801 may detect a current of PV1 and a current of PV2. It should be understood that both a magnitude of a current and a direction of the current can be detected. For example, a direction of a current flowing from a photovoltaic string to a parallel-connection point A may be determined as a positive direction.

The voltage detection circuit 803 is configured to detect a voltage of the photovoltaic strings connected in parallel. Due to multiple photovoltaic strings being connected in parallel, the voltages of all the photovoltaic strings in a steady state are balanced, that is, the voltages of all the photovoltaic strings in a steady state are similar.

The insulation impedance detection circuit 802 is configured to detect an insulation impedance of the photovoltaic strings connected in parallel to ground. The insulation impedance is equal to an overall insulation impedance of the photovoltaic strings connected in parallel.

The controller is configured to determine whether a reverse connection fault occurs in the photovoltaic strings based on the current, the voltage, and the insulation impedance.

With the combiner device according to the embodiments of the present disclosure, it can be accurately determined, based on the three parameters of current, voltage, and insulation impedance, whether a reverse connection fault occurs in photovoltaic strings. It cannot be accurately determined whether a reverse connection fault occurs only based on a current due to that other faults may also cause a reverse current. For example, when a current of a photovoltaic string is reversed and an insulation impedance is less than a preset impedance value, it indicates that a short-circuit fault occurs, rather than a reverse connection fault. When a voltage is greater than a preset voltage and a current is reversed, it indicates a voltage mismatch fault occurs. Only when an absolute value of a voltage is less than a preset voltage, an insulation impedance is greater than a preset impedance value and a current is reversed, it is determined that a reverse connection fault occurs. The maintenance personnel dismantle a reversely connected photovoltaic string and then reconnect the photovoltaic string only in case of a reverse connection fault occurs, and other corresponding operations are performed for other faults.

Specifically, the combiner device according to the embodiments of the present disclosure may determine whether a reverse connection fault occurs in photovoltaic strings, and may determine whether a voltage mismatch or a cable-to-ground short circuit fault occurs in the photovoltaic strings. Detailed descriptions are provided below.

The controller is configured to determine that a reverse connection fault occurs in a first photovoltaic string in a case that an absolute value of the voltage is less than a preset voltage, the insulation impedance is greater than a preset impedance value and a current of the first photovoltaic string is less than zero. The first photovoltaic string is any one of the at least two photovoltaic strings connected in parallel.

Each of photovoltaic modules in the photovoltaic strings includes a diode reversely connected in parallel. The preset voltage is greater than a sum of conduction voltage drops of diodes reversely connected in parallel in the photovoltaic strings, and less than open-circuit voltages of all the photovoltaic strings. That is, the preset voltage is less than a minimum open-circuit voltage of all the photovoltaic strings.

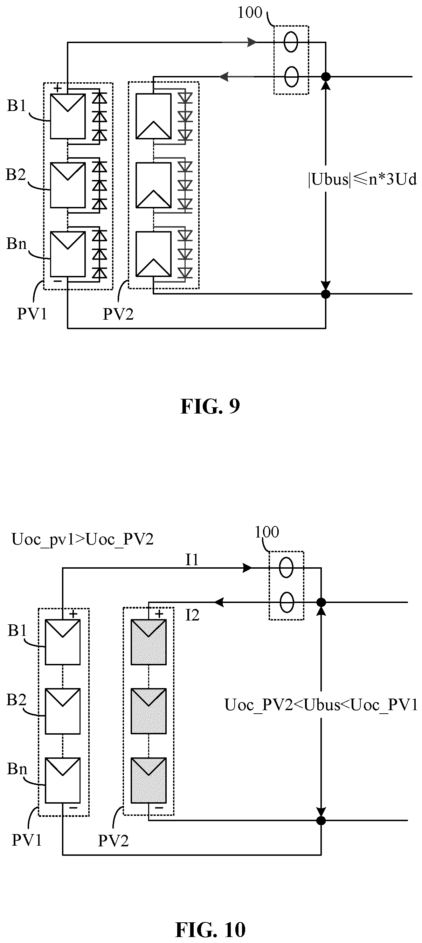

Referring to FIG. 9, FIG. 9 is a schematic diagram of photovoltaic strings connected in parallel according to another embodiment of the present disclosure.

From FIG. 9, it can be seen that each of photovoltaic modules in the photovoltaic strings includes diodes reversely connected in parallel. Descriptions are provided by taking each of photovoltaic modules being connected with three diodes reversely in parallel shown in FIG. 9 as an example. In addition, in FIG. 9, PV2 being reversely connected is taken as an example for descriptions. A reverse current flows through PV2.

Due to the diodes reversely connected in parallel, the reverse current of PV2 flows through the solar cells in the photovoltaic module or through the diodes reversely connected in parallel. Therefore, the voltage Ubus at the parallel-connection point (or called as a combining point) is limited to be less than a sum of maximum conduction voltage drops of the diodes reversely connected in parallel in each of the photovoltaic modules connected in series in the photovoltaic strings. Taking three diodes being reversely connected in parallel with each of the photovoltaic modules as an example, a photovoltaic string includes n photovoltaic modules connected in series, and thus a maximum conduction voltage drop of the diodes reversely connected in parallel is equal to n*3Ud, where Ud represents a conduction voltage drop of a diode and generally Ud<0.7V. Due to that the voltage Ubus between the positive electrode and the negative pole at the parallel-connection point may be positive or negative, it is required to determine based on an absolute value of Ubus, that is, it is determined that |Ubus|≤n*3Ud.

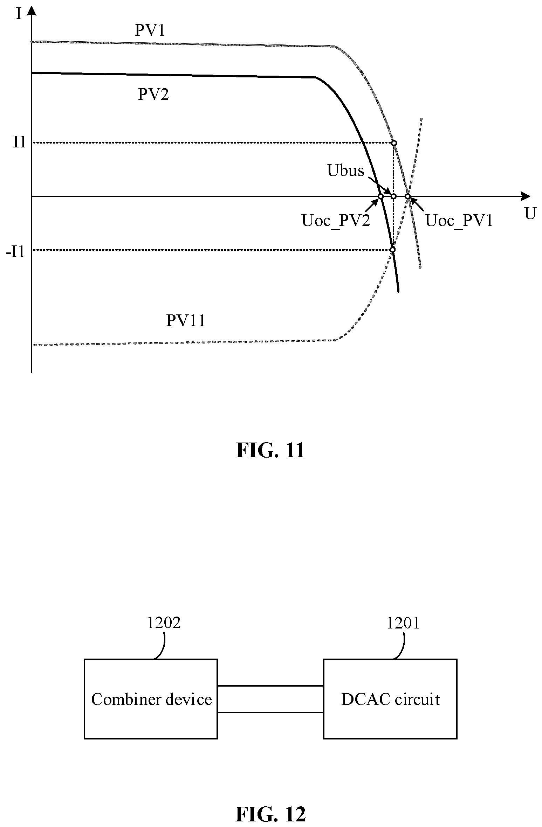

Below, a voltage mismatch is described with reference to FIG. 10 and FIG. 11. Referring to FIG. 10, FIG. 10 is a schematic diagram showing a voltage mismatch principle according to an embodiment of the present disclosure. Referring to FIG. 11, FIG. 11 is a schematic diagram showing IV curves of photovoltaic strings connected in parallel according to an embodiment of the present disclosure.

In FIG. 11, PV1 represents an IV curve of a photovoltaic string PV1, and PV2 represents an IV curve of a photovoltaic string PV2. For the IV curves, the horizontal axis represents voltages U and the vertical axis represents currents I. PV11 represents a mirror curve of the IV curve of the photovoltaic string PV1 relative to the horizontal axis.

The voltage of PV1 is greater than the voltage of PV2. When the voltages of the photovoltaic strings are mismatched, the photovoltaic string PV1 with a higher open-circuit voltage Uoc_PV1 injects a current in reverse to the photovoltaic string PV2 with a lower open-circuit voltage Uoc_PV2, that is, Uoc_PV2<Uoc_PV1. For example, PV1 operates in a first quadrant (Ubus, I1) of the I-V curve, and PV2 operates in a fourth quadrant (Ubus, -I1) of the I-V curve. The voltage Ubus at the combining point is limited between open-circuit voltages of the two photovoltaic strings, that is, Uoc_PV2<Ubus<Uoc_PV1.

Therefore, the preset voltage in the embodiments of the present disclosure is less than the open-circuit voltages of all the photovoltaic strings, that is, less than a minimum open-circuit voltage. Due to that the open-circuit voltages of the photovoltaic strings are greater than the sum of the maximum conduction voltage drops of the diodes reversely connected in parallel with the photovoltaic modules, the voltage Ubus at the combining point may be used as a criterion for distinguishing a photovoltaic string being reversely connected or a voltage mismatch of photovoltaic strings.

The controller is further configured to determine that a voltage mismatch fault occurs in a first photovoltaic string in a case that the voltage is greater than the preset voltage and the current of the first photovoltaic string is less than zero. The first photovoltaic string is any one of the at least two photovoltaic strings connected in parallel.

The controller is further configured to determine that a short-circuit fault occurs in a first photovoltaic string in a case that the insulation impedance is less than the preset impedance value and the current of the first photovoltaic string is less than zero. The first photovoltaic string is any one of the at least two photovoltaic strings connected in parallel.

With the combiner device according to the embodiments of the present disclosure, it can be accurately detected whether a photovoltaic string is reversely connected, and it can be further accurately detected whether a voltage mismatch, that is, a voltage imbalance, occurs in photovoltaic string, or a photovoltaic string is short circuited to ground. Therefore, various faults can be accurately determined, facilitating subsequent accurate repairs.

Based on the combiner device according to the above embodiments, a photovoltaic system is further provided according to an embodiment of the present disclosure. Detailed descriptions are provided below in conjunction with accompanying drawings.

Referring to FIG. 12, FIG. 12 is a schematic diagram of a photovoltaic system according to an embodiment of the present disclosure.

The photovoltaic system according to the embodiment includes a DCAC circuit 1201 and the combiner device 1202 described in the above embodiments. An output terminal of the convergence device 1202 is connected to an input terminal of the DCAC circuit 1201.

In the embodiments of the present disclosure, the number of combiner device 1202 included in the photovoltaic system is not limited, and the number of photovoltaic strings included in the combiner device 1202 is not limited. In addition, the combiner device 1202 may be integrated in an inverter, that is, the inverter includes the combiner device and the DCAC circuit 1201. The controller may be the controller of the inverter.

With the photovoltaic system according to the embodiments of the present disclosure, it can be accurately detected whether a reverse connection fault occurs in a photovoltaic string. When a reverse connection fault is detected, the reversely connected photovoltaic string may be promptly removed and then correctly reconnected. Therefore, with the photovoltaic system according to the embodiments of the present disclosure, the operation and maintenance personnel can be accurately guided to quickly locate and repair faults, effectively reducing the inconvenience caused by incorrect fault determinations, thereby improving photovoltaic power generation and efficiency.

Based on the combiner device and the photovoltaic system according to the above embodiments, a fault detection method is further provided according to an embodiment of the present disclosure. Detailed descriptions are provided below in conjunction with accompanying drawings. The specific principles described in the above embodiments of the combiner device are not repeated in the embodiments of the method, and one may refer to the descriptions in the embodiments of the combiner device.

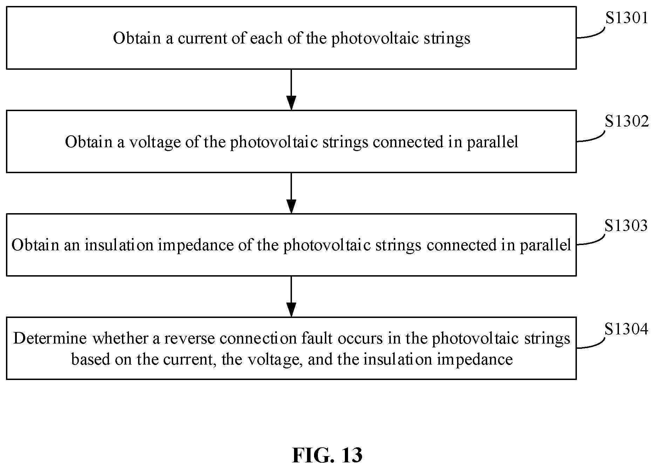

Referring to FIG. 13, FIG. 13 is a flowchart of a fault detection method according to an embodiment of the present disclosure.

The fault detection method according to the embodiment is applied to a photovoltaic system. The photovoltaic system includes a DCAC circuit and at least two photovoltaic strings connected in parallel.

The fault detection method includes the following steps S1301 to S1304.

In step S1301, a current of each of the photovoltaic strings is obtained.

In step S1302, a voltage of the photovoltaic strings connected in parallel is obtained.

In step S1303, an insulation impedance of the photovoltaic strings connected in parallel is obtained.

It should be understood that there is no order for the steps S1301 to S1303.

In step S1304, it is determined whether a reverse connection fault occurs in the photovoltaic strings based on the current, the voltage, and the insulation impedance.

It is determined whether a reverse connection fault occurs in the photovoltaic strings based on the current, the voltage, and the insulation impedance by: determining that a reverse connection fault occurs in a first photovoltaic string in a case that an absolute value of the voltage is less than a preset voltage, the insulation impedance is greater than a preset impedance value and a current of the first photovoltaic string is less than zero. The first photovoltaic string is any one of the at least two photovoltaic strings connected in parallel.

Each of photovoltaic modules in the photovoltaic strings includes a diode reversely connected in parallel. The preset voltage is greater than a sum of conduction voltage drops of diodes reversely connected in parallel in the photovoltaic strings and less than open-circuit voltages of all the photovoltaic strings.

In addition, the fault detection method according to the embodiment of the present disclosure further includes: determining that a voltage mismatch fault occurs in a first photovoltaic string in a case that the voltage is greater than the preset voltage and the current of the first photovoltaic string is less than zero. The first photovoltaic string is any one of the at least two photovoltaic strings connected in parallel.

It should be understood that in the embodiments of the present disclosure, a current of a photovoltaic string being less than zero indicates that the current is reversed. For a direction of a current, it may be defined that when the current flows in a forward direction, the current is positive.

In addition, the fault detection method according to the embodiment of the present disclosure further includes: determining that a short-circuit fault occurs in a first photovoltaic string in a case that the insulation impedance is less than the preset impedance value and the current of the first photovoltaic string is less than zero. The first photovoltaic string is any one of the at least two photovoltaic strings connected in parallel.

With the combiner device according to the embodiments of the present disclosure, it can be accurately determined, based on the three parameters of current, voltage, and insulation impedance, whether a reverse connection fault occurs in photovoltaic strings. It cannot be accurately determined whether a reverse connection fault occurs only based on a current due to that other faults may also cause a reverse current. For example, when a current of a photovoltaic string is reversed and an insulation impedance is less than a preset impedance value, it indicates that a short-circuit fault occurs, rather than a reverse connection fault. When a voltage is greater than a preset voltage and a current is reversed, it indicates a voltage mismatch fault occurs. Only when an absolute value of a voltage is less than a preset voltage, an insulation impedance is greater than a preset impedance value and a current is reversed, it is determined that a reverse connection fault occurs. The maintenance personnel dismantle a reversely connected photovoltaic string and then reconnect the photovoltaic string only in case of a reverse connection fault occurs, and other corresponding operations are performed for other faults.

It should be noted that the embodiments in this specification are described in a progressive manner. Each of the embodiments focuses on differences with other embodiments, and the same or similar parts of the embodiments may be with reference to each other. Descriptions of the system or device disclosed in the embodiments are simplified, since the system or device corresponds to the method disclosed in the embodiments, reference may be made to the description of the method for related explanations.

With the description of the embodiments disclosed above, those skilled in the art may implement or use the present disclosure. Various modifications made to the embodiments are apparent to those skilled in the art, and the general principles defined herein may be implemented in other embodiments without departing from the spirit or scope of the present disclosure. Therefore, the present disclosure is not limited to the embodiments described herein, but should comply with the widest scope consistent with the principles and novel features disclosed herein.

## Claims

1. A combiner device, comprising at least two photovoltaic strings connected in parallel, and further comprising: a current detection circuit, a voltage detection circuit, an insulation impedance detection circuit, and a controller; wherein
the current detection circuit is configured to detect a current of each of the photovoltaic strings;
the voltage detection circuit is configured to detect a voltage of the photovoltaic strings connected in parallel;
the insulation impedance detection circuit is configured to detect an insulation impedance of the photovoltaic strings connected in parallel; and
the controller is configured to determine whether a reverse connection fault occurs in the photovoltaic strings based on the current, the voltage, and the insulation impedance.

2. The combiner device according to claim 1, wherein the controller is configured to determine that a reverse connection fault occurs in a first photovoltaic string in a case that an absolute value of the voltage is less than a preset voltage, the insulation impedance is greater than a preset impedance value and a current of the first photovoltaic string is less than zero, wherein the first photovoltaic string is any one of the at least two photovoltaic strings connected in parallel.

3. The combiner device according to claim 1 or 2, wherein the controller is further configured to determine that a voltage mismatch fault occurs in a first photovoltaic string in a case that the voltage is greater than the preset voltage and the current of the first photovoltaic string is less than zero, wherein the first photovoltaic string is any one of the at least two photovoltaic strings connected in parallel.

4. The combiner device according to claim 1 or 2, wherein the controller is further configured to determine that a short-circuit fault occurs in a first photovoltaic string in a case that the insulation impedance is less than the preset impedance value and the current of the first photovoltaic string is less than zero, wherein the first photovoltaic string is any one of the at least two photovoltaic strings connected in parallel.

5. The combiner device according to claim 2 or 3, wherein each of photovoltaic modules in the photovoltaic strings comprises a diode reversely connected in parallel, and the preset voltage is greater than a sum of conduction voltage drops of diodes reversely connected in parallel in the photovoltaic strings and less than open-circuit voltages of all the photovoltaic strings.

6. A photovoltaic system, comprising:
a DCAC circuit; and
at least one combiner device according to any one of claims 1 to 5; wherein
an output terminal of the combiner device is connected to an input terminal of the DCAC circuit.

7. A fault detection method, applied to a photovoltaic system comprising a DCAC circuit and at least two photovoltaic strings connected in parallel;
wherein the method comprises:
obtaining a current of each of the photovoltaic strings;
obtaining a voltage of the photovoltaic strings connected in parallel;
obtaining an insulation impedance of the photovoltaic strings connected in parallel; and
determining whether a reverse connection fault occurs in the photovoltaic strings based on the current, the voltage, and the insulation impedance.

8. The fault detection method according to claim 7, wherein the determining whether a reverse connection fault occurs in the photovoltaic strings based on the current, the voltage, and the insulation impedance comprises:
determining that a reverse connection fault occurs in a first photovoltaic string in a case that an absolute value of the voltage is less than a preset voltage, the insulation impedance is greater than a preset impedance value and a current of the first photovoltaic string is less than zero, wherein the first photovoltaic string is any one of the at least two photovoltaic strings connected in parallel.

9. The fault detection method according to claim 7, further comprising:
determining that a voltage mismatch fault occurs in a first photovoltaic string in a case that the voltage is greater than the preset voltage and the current of the first photovoltaic string is less than zero, wherein the first photovoltaic string is any one of the at least two photovoltaic strings connected in parallel.

10. The fault detection method according to claim 7, further comprising:
determining that a short-circuit fault occurs in a first photovoltaic string in a case that the insulation impedance is less than the preset impedance value and the current of the first photovoltaic string is less than zero, wherein the first photovoltaic string is any one of the at least two photovoltaic strings connected in parallel.

11. The fault detection method according to any one of claims 7 to 10, wherein each of photovoltaic modules in the photovoltaic strings comprises a diode reversely connected in parallel, and the preset voltage is greater than a sum of conduction voltage drops of diodes reversely connected in parallel in the photovoltaic strings and less than open-circuit voltages of all the photovoltaic strings.
